# EUROPEAN PATENT APPLICATION

(11) **EP 4 783 820 A1**
(43) Date of publication of application: **29.07.2026**
(21) Application number: 26154647.7
(22) Date of filing: 28.01.2026
(51) Int. Cl.: H10W 70/65, H10W 90/00

(54) **PACKAGING STRUCTURE FOR A SURFACE-MOUNTING, POWER MODULE COMPRISING A PLURALITY OF SEMICONDUCTOR ELECTRONIC DEVICES**

(30) Priority: 28.01.2025 IT 202500001470
(71) Applicant: STMicroelectronics International N.V., 1228 Plan-les-Ouates, Geneva (CH); Shenzhen STS Microelectronics Co., Ltd., Shenzhen 518048 (CN)
(72) Inventor: MINOTTI, Agatino, 20864 Agrate Brianza (MB) (IT); CATAUDO, Sebastiano, 20864 Agrate Brianza (MB) (IT); SHAN, Shi Bai, 518048 Shenzhen (CN); ZHAO, Qing Qing, 518048 Shenzhen (CN); YUAN, Wei, 518048 Shenzhen (CN); WEI, Zai Bao, 518048 Shenzhen (CN)
(74) Representative: Studio Torta S.p.A.

(57) **Abstract**

A power module (30) has a multilayer support (50) forming a dissipating plate (49) and conductive islands (55, 56). A first die (51A) has a lower face coupled to the first island (55) and a second die (51B) has a lower face coupled to the second island (56). A package (31) encapsulates the support (30), the first and the second dice (51A, 51B), with the dissipating plate (49) formed in an opening of a lower main surface (32A) of the package (31) and flush therewith. A first power pin (36) protrudes from a first side surface (32A) of the package and is coupled to a first pad (61) of the first die (51A). A second power pin (38) protrudes from a second side surface (32B) of the package and is coupled to a first pad (61) of the second die (51B). A saddle element (70) extends at a distance over the first die (51A) and is formed by a power terminal (47) flush with an upper main surface (33A) of the package (31) and by legs (72) extending from the power terminal and bonded to the first island (55).

## Description

### Technical Field

The present invention relates to a packaging structure for a surface-mounting power module, comprising a plurality of semiconductor electronic devices.

### Background

As is known, high-voltage and/or high-current power semiconductor devices (e.g., superjunction transistors with silicon substrate, vertical transistors with silicon carbide (SiC) or silicon (Si) substrate, planar MOSFET transistors, *e.g.,* gallium nitride (GaN)-based, IGBTs (Insulated-Gate Bipolar Transistors and the like) are widely used in applications, such as power conversion, where they are subject to high or very high voltage bias (with values as high as 1000-2000 V) and have rapidly switching currents flowing therethrough.

These devices are to be packaged so that the finished device has high electrical isolation, adequate separation distance between the leads associated with the terminals, and allows high heat dissipation toward the outside.

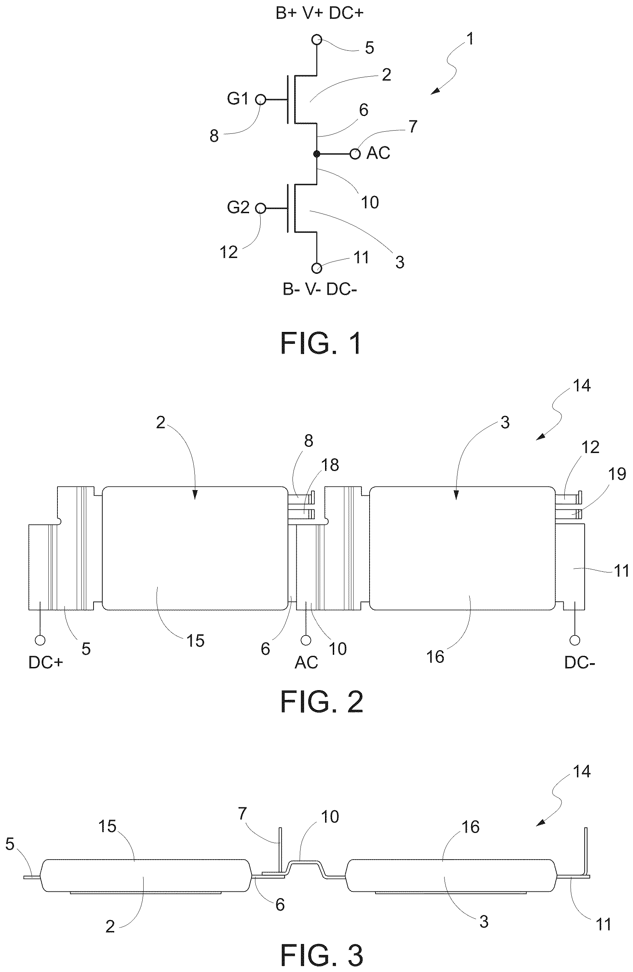

In particular, power modules of this type form half-bridge circuits of the type shown in Figure 1.

In detail, Figure 1 shows a half-bridge circuit 1 formed by the series connection of a first transistor 2 and a second transistor 3, in particular formed by MOSFETs (Metal Oxide Semiconductor Field-Effect Transistors).

In detail, the first transistor 2 has a respective first conduction terminal 5 (drain terminal) configured to be coupled to a first external potential, indicated by B+, V+, DC+, depending on the application; a respective second conduction terminal 6 (source terminal) intended to be coupled to an output terminal 7 configured to provide an output voltage AC; and a respective control terminal 8 (gate terminal) configured to receive a first control voltage G1.

The second transistor 3 has a respective first conduction terminal 10 (drain terminal) configured to be coupled to output terminal 7; a respective second conduction terminal 11 (source terminal) intended to be coupled to a second potential, denoted B-, V-, DC-, depending on the application; and a respective control terminal 12 (gate terminal) configured to receive a second control voltage G2.

In a not shown manner, the first and second transistors 3 may have auxiliary source terminals, also called Kelvin source terminals, for monitoring the current flowing in transistors 2, 3.

In practice, the first potential B+, V+, DC+ and the second potential B-, V-, DC- define an external, generally dc, voltage applied across the power module 1, between the first conduction terminal 5 of the first transistor 2 and the second conduction terminal 11 of the second transistor 2, with the first potential B+, V+, DC+ greater than the second potential B-, V-, DC-.

Therefore, the first transistor 2 is also called "high side transistor", "HS transistor", and the second transistor 3 is also called "low side transistor", "LS transistor".

Currently, in high and very high power applications, the first and second transistors 2, 3 of the half-bridge circuit 1 in Figure 1 are made in respective dice and are individually packaged, as shown in Figures 2 and 3.

In detail, Figures 2 and 3 show a power module 14 where each transistor 2, 3 is packaged in its own package (first and second packages 15, 16) of resin (shown in transparency in Figure 3).

The first and second conduction terminals 5, 6, the control terminal 8 as well as a first Kelvin terminal 18 of the first transistor 2 protrude from the first package 15; the first and second conduction terminals 10, 11, the control terminal 12 as well as a second Kelvin terminal 19 of the second transistor 3 protrude from the second package 16. The second conduction terminal 6 of the first transistor 2 is bonded, for example soldered, to the first conduction terminal 10 of the second transistor 3 at their portions protruding from the packages 15, 16.

In the power module 14 of Figures 2, 3 the current flows from the first conduction terminal 5 of the first transistor 2 to the output terminal 7 and/or from the output terminal 7 to the conduction terminal 10 of the second transistor 3.

The arrangement shown, with the biasing terminals (first conduction terminals 5 of the first transistor 25, second conduction terminal 11 of the second transistor 3) at the farthest positions and AC or phase terminal 7 at the center, is however not optimal in some situations, since it limits the layout of an inverter busbar used by customers and causes the AC phase to be arranged in the middle.

In addition, the known arrangement is bulky.

Thus, an aim of the invention is overcome the drawbacks and limitations of the prior art.

### Summary

According to the present invention, a power module for surface mounting and a process for packaging a power module for surface mounting are provided, as defined in the attached claims.

### Brief Description of the Drawings

For the understanding of the present invention, embodiments thereof are now described, purely as a non-limitative example, with reference to the enclosed drawings, wherein:
- Figure 1 is a schematic electronic representation of a half-bridge circuit;
- Figure 2 is a top plan view of a power module implementing the circuit of Figure 1;
- Figure 3 is a lateral view, with parts in ghost, of the power module of Figure 2;

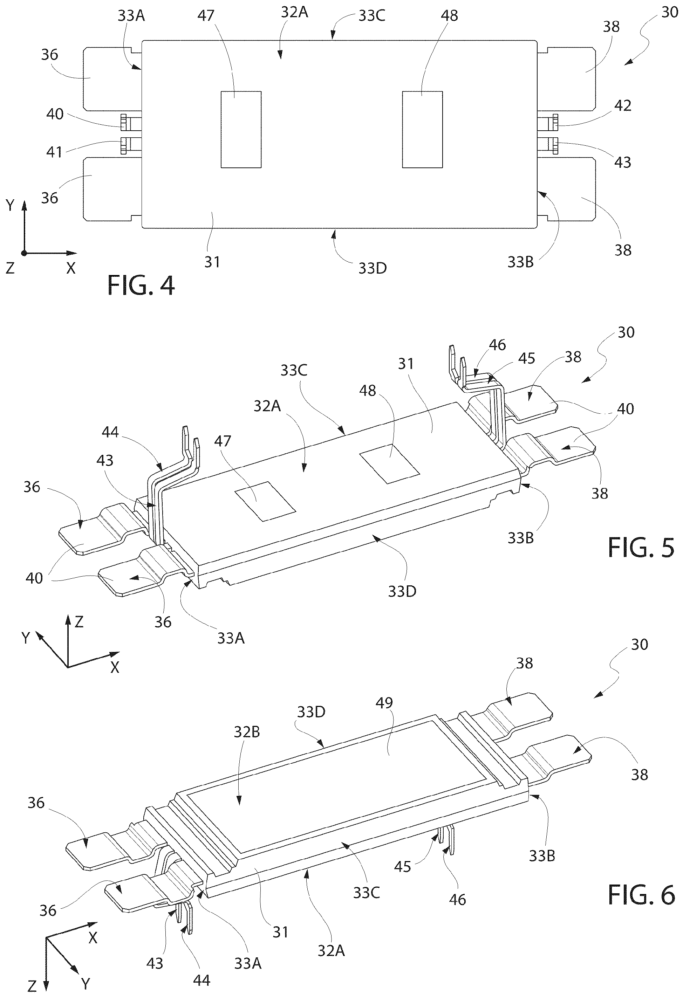

- Figure 4 is a top plan view of a power module, according to an embodiment;
- Figure 5 is a perspective top view of the power module of Figure 4;
- Figure 6 is a perspective bottom view of the power module of Figure 4;

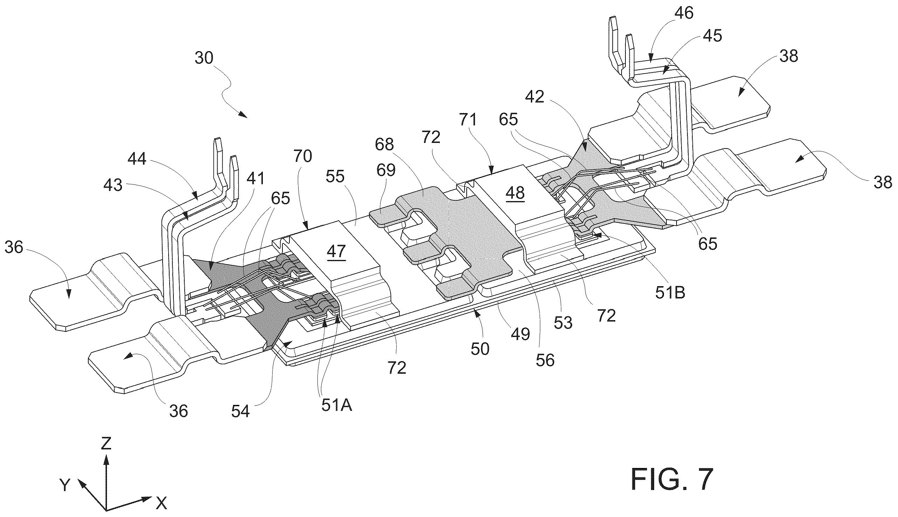

- Figure 7 is a perspective top view of the power module of Figure 4, without a package;

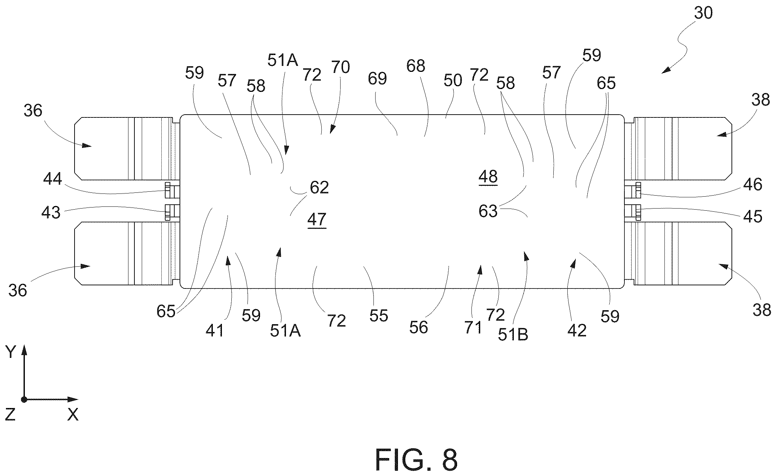

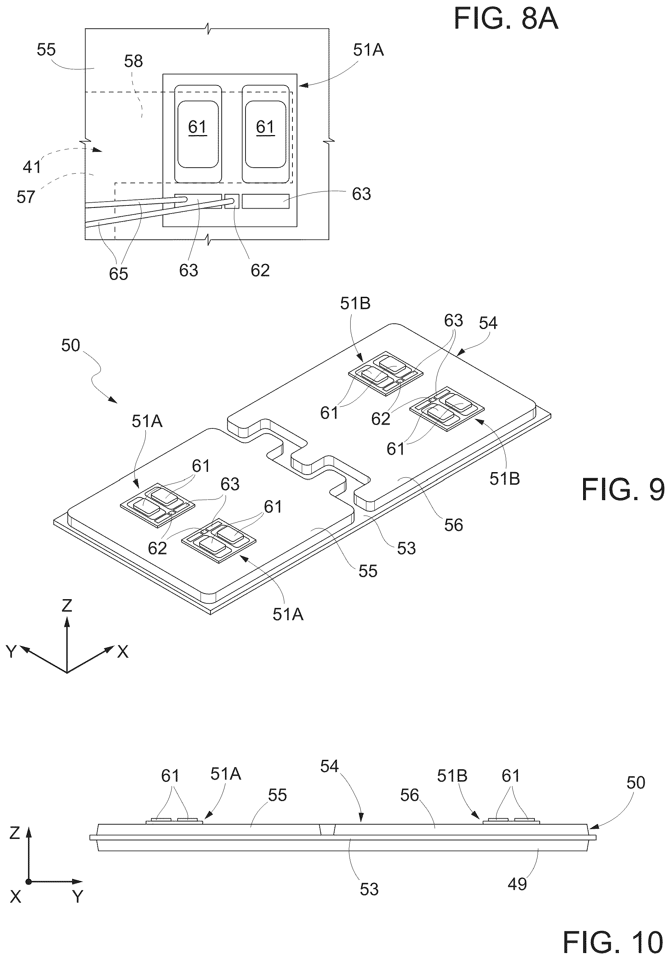

- Figure 8 is a top plan view of the power module, without the package, of Figure 7;
- Figure 8A shows a detail of Figure 8 in top plan view and in enlarged scale;
- Figure 9 is a perspective top view of a support structure of the power module of Figure 4;
- Figure 10 is a lateral view of the support structure of Figure 9, taken along section line X-X;

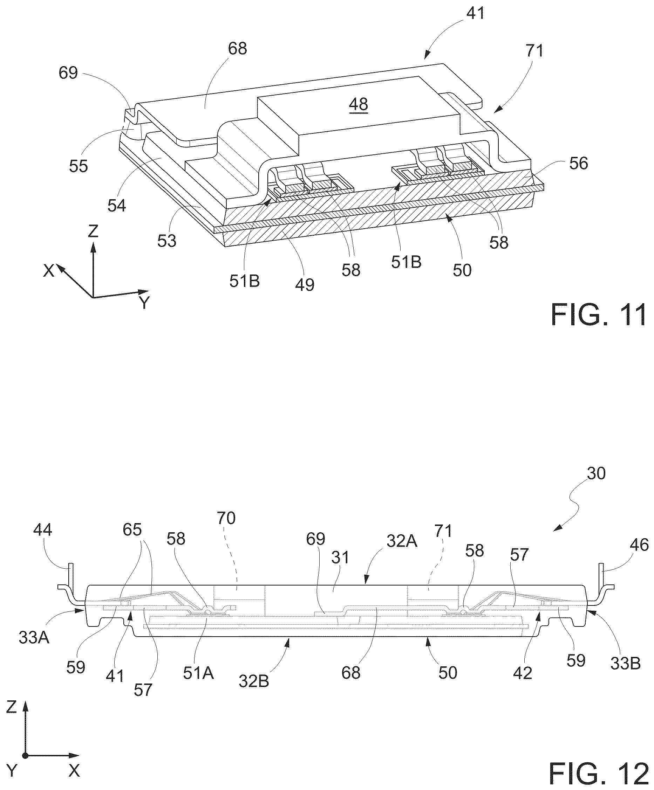

- Figure 11 is a perspective, sectional view of a part of the power module of Figure 7, showing a detail of a saddle element;
- Figure 12 is a lateral view of the power module of figure 4, with parts in ghost;

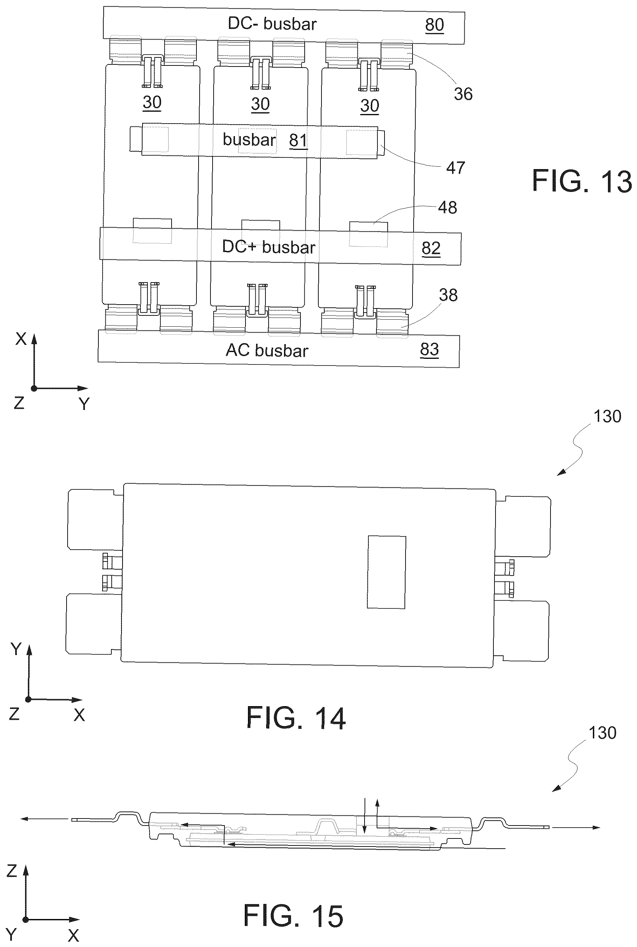

- Figure 13 shows a possible connection of a plurality of power modules of Figures 4-12;
- Figure 14 is a top plan view of a power module, according to another embodiment; and
- Figure 15 is a lateral view of the power module of Figure 14, with parts in ghost, showing the path of currents.

### Description of Embodiments

The following description refers to the arrangement shown in the drawings; consequently, expressions such as "above", "below", "upper", "lower", "top", "bottom", "right", "left" and the like are relative to the attached figures and should not be interpreted in a limiting way.

Figures 4-12 show an embodiment of a power module 30.

Power module 30 is a single package integrated device including a package 31 of insulating material, *e.g.* resin, incapsulating a support 50 and a plurality of dice 51A, 51B (figures 7-12).

Each die 51A, 51B implements a power device, for example to form the first and the second transistors 2 and 3 of half-bridge circuit 1 of figure 1.

In particular, in the exemplary embodiment shown in figure 4-12, power module 30 comprises four power devices 51A, 51B, wherein two power devices (indicated also as first dice/power devices 51A) form the first transistor 2 and are coupled in parallel to each other, and two other power devices (indicated also as second dice/power devices 51B) form the second transistor 3 and are coupled in parallel to each other.

As visible from figures 4-6, the package 31 has a general parallelepiped shape and extends in a lengthwise direction, parallel to a first horizontal axis X of a Cartesian coordinate system XYZ; in a width direction, parallel to a second horizontal axis Y of the Cartesian coordinate system XYZ; and in a thickness direction, parallel to a vertical axis Z of the Cartesian coordinate system XYZ.

As also visible from figures 4-6 and 12, the package 31 has two main surfaces (upper surface 32A, lower surface 32B) and four lateral surfaces (first side surface 33A, second side surface 33B, third side surface 33C and fourth side surface 32F), with first and second side surfaces 33A, 33B arranged opposed to each other in the lengthwise direction of the package 31, transversely thereto; and with third and fourth side surfaces 33C, 33D arranged opposed to each other in the width direction of the package 31, transversely thereto.

Two first power leads 36 protrude from the first side surface 33A; two second power leads 38 protrude from the second side surface 33B. The power leads 36, 38 extend approximately in the lengthwise direction of the package 31 and have each a flat end 40.

As visible from figures 7 and 8, the first power leads 36 are electrically connected together by a first clip element 41; the second power leads 38 are electrically connected together by a second clip element 42, as discussed in detail later below.

Clip elements 41, 42 are formed by shaped sheets of conductive material, in particular metal sheets that are cut and bent to allow to be bonded where it is desired to make contact, that extend at a distance to parts at different voltage, as explained below.

A first and second signal lead 43, 44 protrude from the first side surface 33A; a third and a fourth signal lead 45, 46 protrude from the second side surface 33B.

The signal leads 43-46 are configured to generally extend in a transverse direction to the main surfaces 32A, 32B of the package 31, along the vertical axis Z. In particular, here the signal leads 43-46 protrude with respect to the upper main face 32A of package 31.

Signal leads 43-46 are formed each by a single, bent metal sheet or by more metal sheet portions bonded together.

With particular reference to figures 4 and 5, power module 30 also has a first and a second planar pad 47, 48 extending flush (*e.g.,* coplanar) with a main surface of package 31 in particular here the upper surface 32A. Planar pads 47, 48 extend at a distance along the lengthwise direction of the package 31 in openings of the package 31 and are part of a first and, respectively, a second saddle structure 70, 71, as discussed below.

As shown in figure 6, power module 30 also has a dissipating plate 49, of thermally conducting material, e.g., of metal, extending flush with another main surface, in particular here the lower surface 32B of package 31. Dissipating plate 48 extends in an opening of the package 31 and occupies most of the lower surface 32B.

As visible in particular from figures 7-10, support 50 is formed by a dissipative, insulating, multilayer structure, for example a DCB (Direct Copper Bonding), including a first conductive layer, here forming the dissipating plate 49 and thus identified by reference number 49; an intermediate insulating layer 53 and a second conductive layer 54.

The first and second conductive layers 49, 54 are made of electrically and thermally conductive material, typically metal, in particular copper. The intermediate insulating layer 53 may be a ceramic material, for example of alumina (Al₂O₃), which has excellent characteristics of electrical insulation, but is a good thermal conductor.

The second conductive layer 54 is shaped to form two separate islands (first and second islands) 55, 56 to which the dice 51A, 51B are bonded.

In particular, in the embodiment of figures 4-12, where two power devices form transistors 2, 3, the first dice 51A are bonded to first island 55 and second dice 51B are bonded to second island 56.

Dice 51A, 51B implement power devices of a vertical type, with a first terminal or pad (drain) formed on a first face, here a lower face.

As visible in particular in figures 9, 10, the dice 51A, 51B are coupled with their lower faces to the respective islands 55, 56.

In addition (as represented in the detail of figure 8A wherein, for sake of clarity, the saddle structure 70 has not been represented), the dice 51A, 51B have each first device pads 61 (forming for example, source pads), a second device pad 62 (for example, a gate pad) and at least one third device pad 63 (for example, a Kelvin pad) on the upper face.

As visible in particular in figures 7, 8, first clip element 41 is bonded to the first device pads 61 of the first dice 51A and couples them to the first power leads 36.

Analogously, second clip element 42 is bonded to the first device pads 61 of the second dice 51B and couples them to the second power leads 38.

To this end, as visible from figure 8, the clip elements 41, 42 have each an intermediate portion 57 extending transversely to the lengthwise direction of the package 31, over and at a distance from the respective island 55, 56; first wing portions 58 extending from the respective intermediate portion 57 toward the center of the package 31, to couple with the respective first device pads 61; and second wing portions 59 extending from the respective intermediate portion 57 toward the respective first and second side surface 33A, 33B of the package 31, to couple with the respective first and second power leads 36, 38.

As also visible in figures 7, 8 and 8A, wires 65 couple the second and third device pads 62, 63 of dice 51A, 51B to the respective signal leads 43-46.

In particular, the second device pads 62 of the first dice 51A are coupled together and to the first signal lead 43; the second device pads 62 of the second dice 51B are coupled together and to the third signal lead 45; the third device pads 63 of the first dice 51A are coupled together and to the second signal lead 44; and the fourth device pads 63 of the second dice 51B are coupled together and to the fourth signal lead 45.

In addition, the first clip element 41 has a connecting portion 68 bonded to the second island 56, to electrically couple the first power leads 36, the first device pads 61 of the first dice 51A and the second island 56.

To this end, the connecting portion 68 of the first clip element 41 extends from the first wing portions 58 of first clip element 41 over the first island 55, at a distance, and has feet 69 bonded to the second island 56.

The saddle structures 70, 71, see also figure 11, are conductive structures that couple the islands 55, 56 to the outside. To this end, each saddle structure 70 comprises a central portion, forming the planar pad 47, respectively 48, and two legs 72 extending from the central portion and bonded to a respective island 55, 56.

The saddle structures 70, 71 are *e.g.* formed by shaped metal sheets that extend over the respective dice 51A, 51B and the respective first wing portions 58 at a distance therefrom to avoid electric contact.

Thereby, the planar pads 47, 48 are in electrical contact with the respective island 55, 58 and at a distance from the dice 51A, 51B and clips 41, 42 to satisfy creepage requirements.

The power module 30 of figures 4-12 may be manufactured by:
forming the first and the second islands 55, 56, for example by shaping the second conductive layer 54 of support 50 by etching;
bonding dice 51A, 51B to respective island 55, 56, for example by soldering or sintering;
bonding clip elements 41, 42 to the first device pads 61 of the respective dice 51A, 51B and bonding feet 69 of the first clip element 41 to the second island 56, for example by soldering or sintering;
if the power leads 36, 38 are separate elements from the clip elements 41, 42, bonding them to the clip elements 41, 42. If power leads 36, 38 and signal leads 43-46 belong to a lead-frame, also bonding the signal leads 43-46 in this same step, otherwise, bonding them in subsequent steps;
bonding wires 65 to the second and third device pads 62, 63 and to the signal leads 43-46, by any wire bonding technique;
bonding the saddle structures 70, 71 to the respective island 55, 56, for example by soldering or sintering; and
molding package 31 so that resins fills the space between the dice 51A, 51B, the clip elements 41, 42 and the internal portion of the saddle structures 70, 71 and of the leads 36, 38, 41-46 and so that the power leads 36, 38 and the signal leads 43-46 protrude from the side surfaces 33A, 33B of the package 31;
grinding the resin (if needed) so that the dissipating plate 49 is flush with the lower surface 32B and the planar pads 47, 48 are flush with the upper surface 32A of package 31; and
cropping the signal leads 43-46 and the power leads 36, 38.

In this way, the half-bridge circuit 1 of figure 1 may be obtained, with planar pads 47, 48 forming first conduction terminal 5, coupled to the first external potential B+, V+, DC+ and, respectively, the output terminal 7 proving output voltage AV.

In addition, first power leads 36 also form first conduction terminal 5 proving voltage AC (phase).

Second power leads 38 form the second conduction terminal 11 of figure 1, coupled to second potential B-, V-, DC-; first and third signal leads 43, 45 form gate terminals 8, 12 to receive first and second control voltage G1, G2.

Second and fourth signal leads 44, 46 are intended to supply additional source currents (so-called Kelvin pins), indicated in figures 4, 5 as K1, K2.

In this way, the power module 30 has low parasitic inductances; creepage distances are ensured, any reject pin hole, present in other packages after molding of the package 31, may be avoided, thanks to the presence of the saddle elements, so that reject pins may push directly on the them; manufacturing costs may be reduced.

The use of a DCB substrate to form support 50 is particularly advantageous, since it allows the lower surface 32B of the package 31 to be electrically insulated from the dice 51A, 51B, even at high voltages, but is thermally connected thereto and is able to effectively dissipating heat generated during operation.

With other simple adaptations, it is possible to have output terminal 7 and second conduction terminal 11 accessible from above the package, to adapt to clients' requirements.

The power module 30 may be coupled in parallel with similar power modules 30, as shown in figure 13, where a DC-busbar 80 is bonded to the second power leads 38 of all power modules 30; a common busbar 81 (AC) is bonded to the second planar pads 48 of all power modules 30; a DC+ busbar 82 is bonded to the first planar pads 47 of all power modules 30; and an AC busbar 83 is bonded to the first power leads 36 of all power modules 30.

Figures 14 and 15 show a power module 130 that has a single planar pad.

Power module 130 of figures 14 and 15 has a simplified structure with respect to power module 30 of figures 4-12; thus, its parts that are common with module 30 of figures 4-12 have been designed using the same reference numbers and are not described here.

In detail, planar pad is analog to first planar pad 47 of figures 4-12 and is configured to be coupled with first potential DC+ of figure 1 and thus has been designated by the same reference number 47.

Also in power module 130, the first power leads 36 are configured to be coupled with phase/output voltage AC; the second power leads 38 are configured to be coupled with second potential DC-; the first and third signal leads 43, 45 are configured to be coupled to the first and second control voltage G1, G2; and the second and fourth signal leads 44, 46 are configured to form Kelvin pins K1, K2.

Figure 15 also shows with arrows the flow of currents through power module 130 (the same applies also to module 30 of figures 4-12).

Finally, it is clear that numerous variations and modifications may be made to the power module described and illustrated herein, all falling within the scope of the invention as defined in the attached claims.

For example, the various embodiments described above can be combined to provide further embodiments.

Summarizing, the present disclosure regards a power module and a method as indicated in the following examples.

Example 1. A power module (30; 130) for surface mounting, the power module comprising:
a multilayer support (50) comprising a dissipating plate (49), an insulating layer (53) over the dissipating plate, a first conductive island (55) and a second conductive island (56) over the insulating layer, the first and second conductive islands electrically isolated from each other;
a first die (51A) having a first face coupled to the first island (55);
a second die (51B) having a first face coupled to the second island (56);
a package (31) encapsulating the support (30), the first and the second dice (51A,51B), the package having a first and a second main face (32A, 32B), a first and a second side surface (33A, 33B), the dissipating plate (49) flush with the second main surface (32A) of the package (31);
a first power pin (36) protruding from the first side surface (32A) of the package and coupled to a first pad (61) on a second face of the first die (51A);
a second power pin (38) protruding from the second side surface (32B) of the package and coupled to a first pad (61) on a second face of the second die (51B); and
a first saddle element (70) extending at a distance over the first or the second die (51A, 51B), the first saddle element comprising a first power terminal (47) flush with the first main surface (32A) of the package (31) and legs (72) extending from the first power terminal and bonded to the first or the second island (55, 56).

Example 2. A power module according to example 1, wherein the first saddle element (70) extends at a distance over the first die (51A) and is bonded to the first island (55).

Example 3. A power module according to the preceding example, further comprising a first clip element (41) coupling the first pad of the first die to the second island, the first clip element (41) having a portion (58) extending under the first saddle element, at a distance and electrically insulated therefrom.

Example 4. A power module according to the preceding example, wherein the first clip element (41) has a portion (58) coupling the first pad (61) of the first die (51A) and the first power pin (36).

Example 5. A power module according to any of the preceding examples, further comprising a second clip element (42) coupling the first pad (61) of the second die (51B) and the second power pin (38).

Example 6. A power module according to any of the preceding examples, further comprising a second saddle element (71) extending over the second die (51B), the second saddle element comprising a second power terminal (48) flush with the first main surface (32A) of the package (31) and legs (72) extending from the second power terminal (48) and bonded to the second island.

Example 7. A power module according to any of the preceding examples, further comprising:
a first signal pin (43) protruding from the first side surface (33A) of the package (31) and coupled to a second pad (62) of the first die (51A); and
a second signal pin (45) protruding from the second side surface (33B) of the package (31) and coupled to a second pad (62) of the second die (51B).

Example 8. A power module according to any of the preceding examples, wherein the first and second power pins (36, 38) have flat ends (40) protruding from the first, and, respectively, the second side surface (33A, 33B) of the package (31), the flat ends (40) extending in a lengthwise direction of the package (31).

Example 9. A power module according to any of the preceding examples, wherein the dissipating plate (49) extends in an opening of the second main surface (32B) of the package (31).

Example 10. A power module according to any of the preceding examples, wherein the first power terminal (47) extends in an opening of the first main surface (32A) of the package (31).

Example 11. A power module according to any of the preceding examples, forming a half-bridge circuit.

Example 12. A process for packaging a power module (30; 130) for surface mounting, comprising:
forming a multilayer support (50) including a dissipating plate (49), an insulating layer (53) over the dissipating plate, a first conductive island (55) and a second conductive island (56) over the insulating layer, the first and second conductive islands electrically isolated from each other;
bonding a first face of a first die (51A) to the first island (55);
bonding a first face of a second die (51B) to the second island (56);
coupling a first power pin (36) to a first pad (61) on a second face of the first die (51A);
coupling a second power pin (38) to a first pad (61) on a second face of the second die (51B);
bonding legs (72) of a first saddle element (70) to the first or the second island (55, 56) so that the first saddle element (70) extends at a distance therefrom, the first saddle element (70) having a first power terminal (47) and the legs (72) extending from the first power terminal; and
molding a package (31) having a first main face (32A), a second main face (32B), a first side surface (33A) and a second side surface (33B), so as to encapsulate the support (30), the first and the second dice (51A, 51B), the first saddle element (70), the first and second power pins (36, 38), with the dissipating plate (49) flush with the second main surface (32A) of the package (31), the first power terminal (47) flush with the first main surface (33A) of the package (31), the first power pin (36) protruding from the first side surface (32A) of the package and the second power pin (38) protruding from the second side surface (32B) of the package.

Example 13. A process according to the preceding example, wherein coupling a first power pin (36) comprises bonding a first clip element (41) to the first pad (61) of the first die (51A) and to the first power pin (36) and coupling a second power pin (38) comprises bonding a second clip element (42) to the first pad (61) of the second die (51B) and to the second power pin (38) and molding a package (31) comprises encapsulating the clip elements (41, 42).

Example 14. A process according to the example 12 or 13, wherein coupling a first power pin (36) and coupling a second power pin (38) comprises arranging a leadframe including the first and second power pins (36, 38) and signal pins (43-46) on the first and second dice (51A, 51B), coupling the signal leads (43-46) to second and third device pads (62, 63) of the first and second dice through wires (65) and, after molding, cropping the first power pin (36), the second power pin (38) and the signal pins (43-46).

## Claims

1. A power module (30; 130) for surface mounting, the power module comprising:
a multilayer support (50) comprising a dissipating plate (49), an insulating layer (53) over the dissipating plate, a first conductive island (55) and a second conductive island (56) over the insulating layer, the first and second conductive islands electrically isolated from each other;
a first die (51A) having a first face coupled to the first island (55);
a second die (51B) having a first face coupled to the second island (56);
a package (31) encapsulating the support (30), the first and the second dice (51A,51B), the package having a first and a second main face (32A, 32B), a first and a second side surface (33A, 33B), the dissipating plate (49) flush with the second main surface (32A) of the package (31);
a first power pin (36) protruding from the first side surface (32A) of the package and coupled to a first pad (61) on a second face of the first die (51A);
a second power pin (38) protruding from the second side surface (32B) of the package and coupled to a first pad (61) on a second face of the second die (51B); and
a first saddle element (70) extending at a distance over the first or the second die (51A, 51B), the first saddle element comprising a first power terminal (47) flush with the first main surface (32A) of the package (31) and legs (72) extending from the first power terminal and bonded to the first or the second island (55, 56).

2. A power module according to claim 1, wherein the first saddle element (70) extends at a distance over the first die (51A) and is bonded to the first island (55).

3. A power module according to the preceding claim, further comprising a first clip element (41) coupling the first pad of the first die to the second island, the first clip element (41) having a portion (58) extending under the first saddle element, at a distance and electrically insulated therefrom.

4. A power module according to the preceding claim, wherein the first clip element (41) has a portion (58) coupling the first pad (61) of the first die (51A) and the first power pin (36).

5. A power module according to any of the preceding claims, further comprising a second clip element (42) coupling the first pad (61) of the second die (51B) and the second power pin (38).

6. A power module according to any of the preceding claims, further comprising a second saddle element (71) extending over the second die (51B), the second saddle element comprising a second power terminal (48) flush with the first main surface (32A) of the package (31) and legs (72) extending from the second power terminal (48) and bonded to the second island.

7. A power module according to any of the preceding claims, further comprising:
a first signal pin (43) protruding from the first side surface (33A) of the package (31) and coupled to a second pad (62) of the first die (51A); and
a second signal pin (45) protruding from the second side surface (33B) of the package (31) and coupled to a second pad (62) of the second die (51B).

8. A power module according to any of the preceding claims, wherein the first and second power pins (36, 38) have flat ends (40) protruding from the first, and, respectively, the second side surface (33A, 33B) of the package (31), the flat ends (40) extending in a lengthwise direction of the package (31).

9. A power module according to any of the preceding claims, wherein the dissipating plate (49) extends in an opening of the second main surface (32B) of the package (31).

10. A power module according to any of the preceding claims, wherein the first power terminal (47) extends in an opening of the first main surface (32A) of the package (31).

11. A power module according to any of the preceding claims, forming a half-bridge circuit.

12. A process for packaging a power module (30; 130) for surface mounting, comprising:
forming a multilayer support (50) including a dissipating plate (49), an insulating layer (53) over the dissipating plate, a first conductive island (55) and a second conductive island (56) over the insulating layer, the first and second conductive islands electrically isolated from each other;
bonding a first face of a first die (51A) to the first island (55);
bonding a first face of a second die (51B) to the second island (56);
coupling a first power pin (36) to a first pad (61) on a second face of the first die (51A);
coupling a second power pin (38) to a first pad (61) on a second face of the second die (51B);
bonding legs (72) of a first saddle element (70) to the first or the second island (55, 56) so that the first saddle element (70) extends at a distance therefrom, the first saddle element (70) having a first power terminal (47) and the legs (72) extending from the first power terminal; and
molding a package (31) having a first main face (32A), a second main face (32B), a first side surface (33A) and a second side surface (33B), so as to encapsulate the support (30), the first and the second dice (51A, 51B), the first saddle element (70), the first and second power pins (36, 38), with the dissipating plate (49) flush with the second main surface (32A) of the package (31), the first power terminal (47) flush with the first main surface (33A) of the package (31), the first power pin (36) protruding from the first side surface (32A) of the package and the second power pin (38) protruding from the second side surface (32B) of the package.

13. A process according to the preceding claim, wherein coupling a first power pin (36) comprises bonding a first clip element (41) to the first pad (61) of the first die (51A) and to the first power pin (36) and coupling a second power pin (38) comprises bonding a second clip element (42) to the first pad (61) of the second die (51B) and to the second power pin (38) and molding a package (31) comprises encapsulating the clip elements (41, 42).

14. A process according to the claim 12 or 13, wherein coupling a first power pin (36) and coupling a second power pin (38) comprises arranging a leadframe including the first and second power pins (36, 38) and signal pins (43-46) on the first and second dice (51A, 51B), coupling the signal leads (43-46) to second and third device pads (62, 63) of the first and second dice through wires (65) and, after molding, cropping the first power pin (36), the second power pin (38) and the signal pins (43-46).
